# EUROPEAN PATENT APPLICATION

(11) **EP 4 818 713 A1**
(43) Date of publication of application: **07.10.2026**
(21) Application number: 25382202.7
(22) Date of filing: 05.03.2025
(51) Int. Cl.: G01R 31/34, G01R 31/52

(54) **METHOD AND SYSTEM FOR THE DETECTION AND LOCATION OF GROUND FAULTS IN THE WINDINGS OF ELECTRIC MACHINES**

(71) Applicant: Universidad del País Vasco/Euskal Herriko Unibertsitatea, 48940 Leioa, Vizcaya (ES); Fundación Tecnalia Research & Innovation, 48160 Derio - Bizkaia (ES)
(72) Inventor: GUERRERO GRANADOS, José Manuel, Leioa, BIZKAIA (ES); PÉREZ GARCÍA, Jesús Mauricio, Leioa, BIZKAIA (ES); EGUÍA LÓPEZ, Pablo, Leioa, BIZKAIA (ES); PEREA OLABARRIA, Eugenio, Derio, BIZKAIA (ES); PUJANA GOITIA, Ainhoa, Derio, BIZKAIA (ES)
(74) Representative: Balder IP Law, S.L.

(57) **Abstract**

The present invention relates to a method and system for the detection and location of ground faults in the windings of electric machines based on the voltage measurement in a grounding impedance that can be commutated between at least two points of the electrical system to be protected and on the voltage measurement of the winding of the electric machine, which allows detecting whether the fault is inside or outside the machine, distinguishing the phase with the defect, and locating the fault inside the winding. The invention allows said detection and location of the fault with the system in operation and regardless of the load level of the machine.

## Description

### OBJECT OF THE INVENTION

The present invention relates to a method and system for the detection and location of ground faults in the windings of electric machines which is capable of detecting whether the fault is inside or outside said machine, distinguishing the faulty phase, and locating the defect inside the faulty winding. The invention allows said detection and location of the fault with the system in operation and regardless of the load level of the machine.

The method and system of the present invention is particularly relevant for systems with rotating, linear, or static electric machines (such as transformers in a non-limiting example of the invention) which have coils or windings in their stator.

### BACKGROUND OF THE INVENTION

Electric machines are a key factor in electrical energy generation and consumption. These machines are responsible for transforming electrical energy into mechanical energy or vice versa if they are considered rotating or linear electric machines, or for increasing or reducing electrical voltage if they are considered electrical transformers.

The conditions of these machines and their long operating times make them prone to electrical failures including, among them, ground faults which occur due to the contact of a part of the circuit, the insulation of which has been considerably deteriorated or completely worn off, with a part external to the circuit at a potential of or close to 0 V. Depending on the type of grounding system of the circuit, this will cause the recirculation of a fault current between the faulty point and the grounding of the system. This current will be zero or only eddy currents if the system is isolated from ground, a low fault current if the system is grounded with high impedance, and a high fault current if the system is grounded with low impedance or rigidly.

In order to protect these machines from more damage caused when a first ground fault is not detected and a second defect occurs, systems and methods capable of detecting this first ground fault before a second defect occurs must be used. In electric machines, there are many inventions available for protecting the machine. In electrical windings, particularly in the stator which is the most valuable part of the machine, the most relevant inventions closest to the system and method of this invention are the following:
- Patent inventions US20144055889A1, CN105655976A, and ES-2536798 B2 are variations of 100% stator-ground protections which allow detecting ground faults in the entire winding of the electric machine using the measurement of voltage in the grounding impedance in the neutral of the electric machine, as well as the measurement of homopolar voltage using an analysis of the frequencies in said impedance or a transformer with an open secondary that allows the measurement. The protection uses the neutral overcurrent protection principle to protect the first part of the winding of the machine, also called 95% stator-ground, and the homopolar voltage as a complement to provide resolution in the 5% of the winding closest to the neutral of the electric machine.
- Patent inventions CN110970872A and JPH0783987A propose protecting the winding of an electric machine using a current injection system between the neutral of said machine and the grounding in said neutral of the electric machine to be protected. Devices of this type are based on the monitoring of this signal during the healthy and faulty states of the machine, allow the detection of a ground fault if a variation occurs in said signal, generally a current the characteristics of which are known to be measurable in the grounding in the neutral once the fault occurs. These systems are expensive protections due to their components, but solve the problem of 100% stator-ground protections in machines that do not have third harmonic voltage for their correct diagnosis.

- Another closely-related invention is described in patent ES-2869451 B2 which claims a system and method having groundings that can be commutated between three parts of a DC system to protect DC storage systems attached to a grounding impedance where voltage is measured. This device allows DC faults to be located, however, the device is not adapted to measure AC ground faults, which does not allow the use thereof in most electric machines.

Most of the preceding inventions allow detecting defects in electric machines using the 100% stator-ground system and locating this defect by means of injection systems, and this represents a significant increase in the investment costs of protection systems. Moreover, the commutable grounding systems have neither been used nor adapted for AC systems, so they are unable to locate these defects under these circumstances. To that end, it is important to design new DC or AC electric machine winding protection systems which allow detecting the defect, identifying the faulty phase, and locating the defect within said faulty phase without using signal injection equipment between neutral and ground, in a safe and economically more viable manner compared to the latter.

### DESCRIPTION OF THE INVENTION

The present invention solves the drawbacks and limitations of the state of the art described above, and to that end there is a need for systems and methods for the detection and location of ground faults in the windings of electric machines that are capable of locating and protecting the electric machine without injecting signals into the power system, for having a small number of parameters to be measured, as well as for there to be as few external devices as possible to perform said location.

To that end, a first aspect of the invention relates to a system for the detection and location of ground faults in the windings of electric machines which allows locating a first ground fault with the system in operation and which is characterized in that it comprises the following subsystems:
- at least one grounding device connected between at least two switches positioned at two different points of the system to be protected and the ground;
- at least one voltage or current meter for measuring voltage or current in the terminal posts of the grounding device, respectively;
- at least one voltage meter for measuring voltage in the phases of the electric machine or for measuring line-to-line voltage between phases of the electric machine;
- a commutation subsystem between at least the two different points of the system to be protected for controlling the switches connected to the grounding device and which allows the grounding to be moved between at least these two points;
- and a master subsystem for the diagnosis of ground faults in electric machines which controls the commutation subsystem and allows knowing the position of the grounding device with respect to the system to be protected, collects the voltage signals/current at least from the preceding meters, for all the previously commutated positions, and is adapted to detect the grounding defect if a voltage and/or current in the grounding device exceeds a certain pre-established threshold.
- Furthermore, the master subsystem for the diagnosis of ground faults is adapted to distinguish the defective phase by means of comparing the phase or line-to-line voltages with respect to the voltage and/or current in the grounding device, and to locate the defect using the phase and/or line voltage and/or current measurements and measurements from the grounding device, for at least two commutation positions of this grounding device, and to estimate the severity of the defect once it is located, and to emit an alarm and diagnostic signal to protective devices external to the system for detection.

Preferably, the grounding device is a grounding impedance for limiting the defect current to low values and for preventing the electric machine to be protected from being damaged with a first ground fault. The impedance has a value suitable to meet the IEC standards for high voltage or low voltage depending on in which system this impedance is installed. The ohmic value there must limit the maximum defect current to a value of 3. 5 or 10 A depending on the machine/system to be protected, or limit the maximum defect current to 50 mA in the case of low-voltage systems.

In a preferred embodiment of the invention, the commutation subsystem for commutating the switches of the points of the system with the grounding device has an electrical interlock between the switches to prevent turn and/or phase short circuit in the case where they are both operated at the same time.

In turn, in another preferred embodiment of the invention the master subsystem for the diagnosis of ground faults:
- detects the ground fault if the voltage in the grounding device, *U_{gnd},* is greater than a certain threshold value, *Uₜₕ,* such that: ${U}_{gnd} > {U}_{th}$ and which can also be applied to current, (*I_{gnd} > Iₜₕ*);
- distinguishes the defective phase such that *U_{gnd}* is in counterphase with the phase-neutral voltage, *Uᵢₙ*, of the faulty phase, either measured or estimated from line voltages, as: ${θ}_{{U}_{gnd}} - {θ}_{{U}_{in}} = 180 ° \pm ε$ where *ε* is the tolerance in angular difference between phasors *U_{gnd}* and *Uᵢₙ*, with "*i*" being the faulty phase;
- locates the position of the grounding defect, x, by solving the following system of equations: $\left\{\begin{matrix}{U}_{gnd . n} = x \frac{{R}_{gnd}}{{R}_{gnd} + {R}_{f}} {U}_{in} \\ {U}_{gnd . ph} = \left(1-x\right) \frac{{R}_{gnd}}{{R}_{gnd} + {R}_{f}} {U}_{in}\end{matrix}\right.$ where *U_{gnd.n}* is the voltage measurement in the grounding device for the commutation position in the neutral of the system to be protected, *U_{gnd.ph}* is the voltage measurement in the grounding device for the commutation position in the terminals of the machine to be protected, *R_{F}* is the fault resistance, which is inversely proportional to the severity of the defect, and *R_{gnd}* is the impedance of the grounding device; therefore: $x = 1 - \frac{1}{1 + \frac{{U}_{gnd . n}}{{U}_{gnd . ph}}}$
- and estimates the severity of the defect once the fault position is known, as: ${R}_{f} = {R}_{gnd} \left(\frac{{xU}_{in}}{{U}_{gnd . n}}-1\right)$

In the case of protection of synchronous electric machines, the phase/line voltage measurement of the machine can also be indirect, using the counter-electromotive force measurement from the vacuum testing of the rotating electric machine to be protected and the rotation frequency thereof for estimating same.

Another aspect of the invention relates to a method for the detection and location of ground faults in the windings of electric machines which allows locating a first ground fault with the system in operation and which is characterized in that it comprises the following steps:
- at least one step of measuring voltages which records the voltage signals in the grounding device and the phase and/or line voltage measurements of the electric machine to be protected;
- at least one step of checking for ground fault where the voltage measurement in the grounding device is compared with a preset trip threshold;
- at least one step of waiting for the commutation of the switches connecting two or more points of the electric machine with the grounding device, sending a switch commutation signal once the previously preset wait time runs out, to perform the diagnosis at another different grounding point of the electric machine to be protected;
- at least one step of commutating the grounding switches which opens a commutator prior to or simultaneously with the introduction of another switch to prevent short circuits without limiting impedance to ground that allows performing the step of measuring voltages from another different point of the electric machine;
- at least one step of calculating the fault position which uses at least two previously described positions and their respective voltage and/or current measurements in the grounding device and in the grounding line and/or phase voltage.

Preferably, in the step of calculating the position of the fault, the diagnosis for distinguishing the faulty phase of the electric machine is performed such that: ${θ}_{{U}_{gnd}} - {θ}_{{U}_{in}} = 180 ° \pm ε$ where *θ_{Ugnd}* is the angle of the phasor of the voltage in the grounding device, *θ_{Uin}* is the voltage angle of faulty phase *"i"* of the electric machine, and ε is the tolerance/deviation set by the user. Furthermore, said step locates the defect within the faulty winding with at least two commutation points such that $x = 1 - \frac{1}{1 + \frac{{U}_{gnd . n}}{{U}_{gnd . ph}}}$ where *U_{gnd.n}* is the voltage measurement in the grounding device for the commutation position in the neutral of the system to be protected, *U_{gnd.ph}* is the voltage measurement in the grounding device for the commutation position in the terminals of the machine to be protected. The modification of this expression depends on the points introduced by means of switches and they vary from the following expressions: $\left\{\begin{matrix}{U}_{gnd . n} = x \frac{{R}_{gnd}}{{R}_{gnd} + {R}_{f}} {U}_{in} \\ {U}_{gnd . ph} = \left(1-x\right) \frac{{R}_{gnd}}{{R}_{gnd} + {R}_{f}} {U}_{in}\end{matrix}\right.$ which are considered in a non-limiting manner as the neutral and phase terminal, respectively, where *Uᵢₙ* is the voltage of faulty phase "*i*"; *R_{gnd}* is the impedance of the grounding device, and *R_{F}* is the fault impedance;
- at least one step of calculating fault impedance which allows estimating the severity of the defect such that: ${R}_{f} = {R}_{gnd} \left(\frac{{xU}_{in}}{{U}_{gnd . n}}-1\right)$ as a resulting non-limiting equation applied to the connection in the neutral of the electric machine to be protected;
- at least one step of emitting alarm and diagnosis with information about ground fault detection, phase having said problem, location of the defect position, and severity of the fault to protective devices external to the invention.

### BRIEF DESCRIPTION OF THE FIGURES

A series of non-limiting exemplary figures which help to better understand the invention are described briefly herein:
Figure 1 shows a wiring diagram of a possible configuration of the system of the invention for a rotating electric machine with phase-neutral voltage measurements.
Figure 2 shows a wiring diagram of another possible configuration of the system of the invention for a rotating electric machine with line voltage measurements.
Figure 3 shows a wiring diagram of the configuration of the system of the invention for a rotating electric machine with phase-neutral voltage measurements of Figure 1 with a ground fault in phase "c".
Figure 4 shows the faulty circuit and voltage distribution of phase "c" of the rotating electric machine of Figure 1 with the grounding device connected in the neutral of the electric machine.
Figure 5 shows the faulty circuit and voltage distribution of phase "c" of the rotating electric machine of Figure 1 with the grounding device connected in phase "c" terminals of the electric machine.
Figure 6 shows the flow diagram of a possible embodiment of the method of the invention.
Figure 7 shows a numerical example based on Figure 3 of the phase voltage waves and in the grounding device in both commutated positions of the switches interchanging the position of the grounding device.

### NUMERICAL REFERENCES OF THE FIGURES

(1) Electric machine;
(2) Winding;
(3) Terminals connected to an AC electrical system;
(4) Neutral;
(5) Grounding device;
(6) Grounding;
(7) Normally open switch;
(8) Normally closed switch;
(9) Master ground fault diagnosis system;
(10) Commutation system;
(11) Phase voltmeter;
(12) Voltage signal in the grounding device;
(13) Voltage signal of the electric machine;
(14) Switch commutation signals;
(15) Alarm and diagnostic signal;
(16) Line voltmeter;
(17) Ground fault;
(18) Fault impedance;
(19) Fault-to-neutral voltage;
(20) Fault impedance voltage;
(21) Phase fault voltage;
(22) Step of measuring voltages;
(23) Step of checking for ground fault;
(24) Step of waiting for commutation;
(25) Step of commutating grounding switches;
(26) Step of calculating fault position;
(27) Step of calculating fault impedance;
(28) Step of emitting diagnosis and alarm;

### DETAILED DESCRIPTION OF THE FIGURES AND PREFERRED EMBODIMENTS

The figures introduced above, which refer to preferred non-limiting embodiments of the invention, will be described in more detail below.

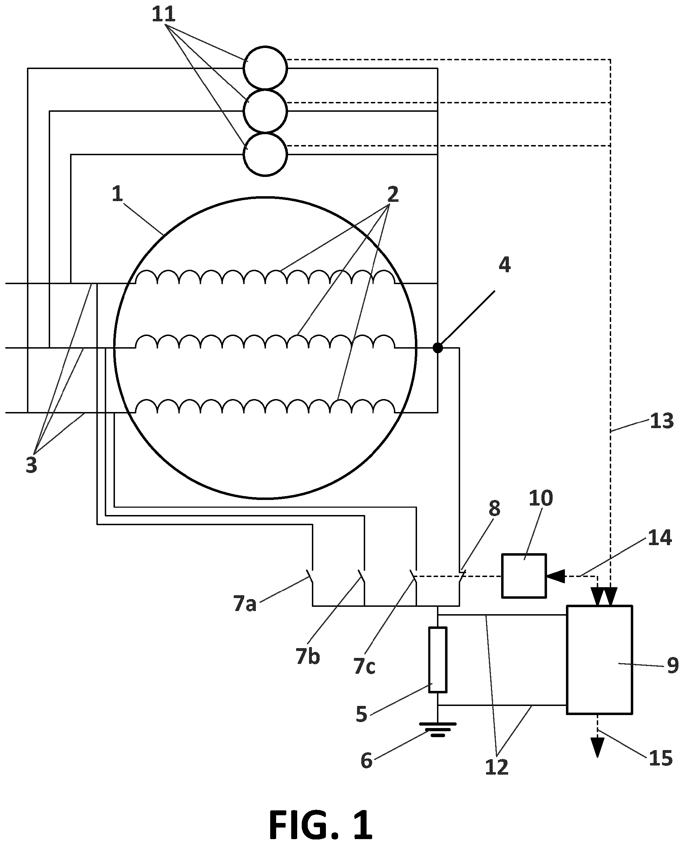

Figure 1 shows a non-limiting example of a possible embodiment of the system of the invention applied to a three-phase electric machine (1) made up of three AC windings (2). These windings are star connected, having their terminals (3) connected to an AC electrical system which powers same, or where it releases its energy (in the case where the electric machine acts as a generator), and having a neutral (4). Between these two points, two switches, one normally open switch (7) and another normally closed switch (8), have been connected to each point described above, respectively. The switches (7, 8) are interlocked with one another and in turn connected to a grounding device (5), which can be an impedance having an ohmic value suitable for limiting the defect current in order to protect the machine, which is connected to ground (6). In this way, the device (5) can move between the terminals and neutral (3, 4) to perform diagnosis in a master fault diagnosis system (9). This system (9) communicates with a commutation subsystem (10) that connects and/or disconnects the interlocked switches (7, 8). In turn, the master system (9) requires the voltage signal in the grounding device (12), (a variant may also be the current going through it), the voltage signal of the electric machine (13), and the commutation signal of the switches (14) to perform its diagnosis and to enable emitting an alarm and diagnostic signal (15) to devices external to the system in order to protect the electric machine with at least the information of defect detection, faulty phase, location within the phase, and estimation of the severity of the fault. The voltage signals of the electric machine are measured with phase voltmeters (11) connected between the terminals (3) and neutral (4).

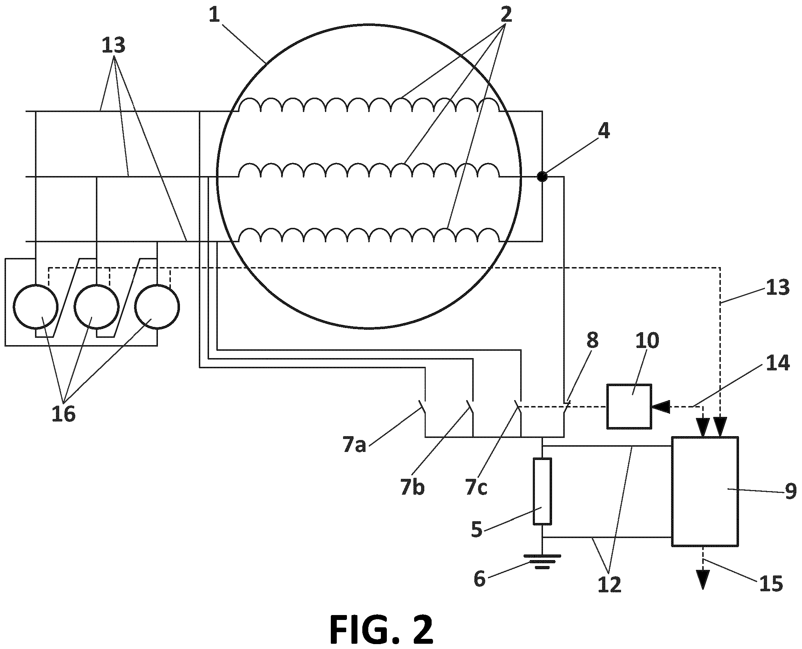

Figure 2 shows a non-limiting example of a possible embodiment of the system of the invention applied to an AC electric machine (1) with three windings (2). In this application, the measured voltages are line voltages using line voltmeters (16). The voltage of faulty phase *Uᵢₙ* is then directly calculated by applying the appropriate transformations for transforming the line or line-to-line voltage to phase voltage. If the system is a sinusoidal system directly connected to the grid, then the phase-neutral voltage of the faulty phase, *Uᵢₙ*, will be root three times lower than the line voltage.

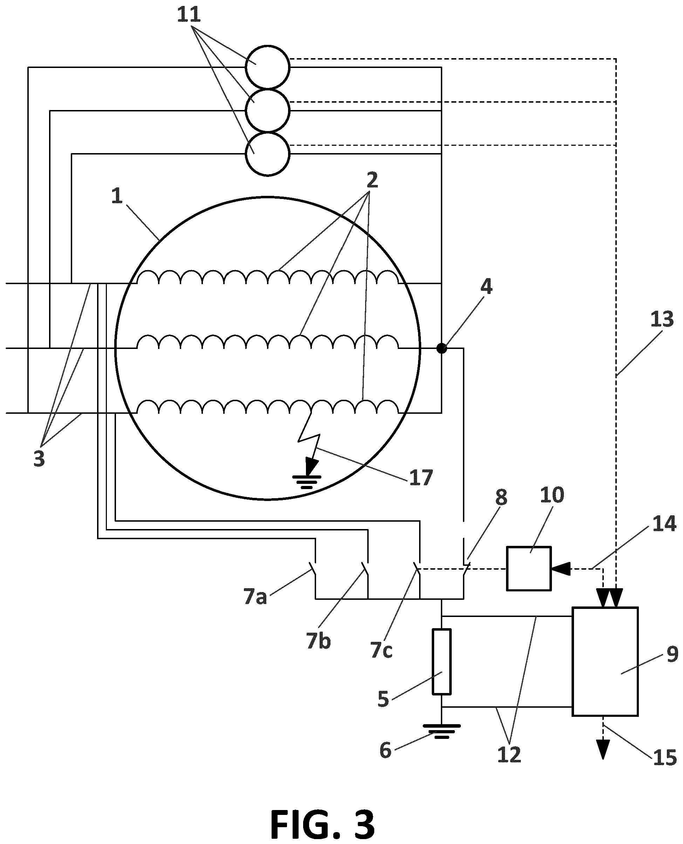

Figure 3 is an example based on the system of Figure 1 in which, in the winding (2) of phase "c", a ground fault (17) occurs in an intermediate area, with a defect position, x, where x is defined as 0% if the fault occurs in the neutral, 100% if the fault occurs in the terminal connected to the grid of the electric machine (1), and intermediate values that will be proportional to the physical distance within the winding to the aforementioned points. In this case, the fault is rigid to ground, but there is the possibility of the severity of the defect being different. To that end, the fault resistance, *R_{F}*, indicates the severity of the defect in an inversely proportional manner.

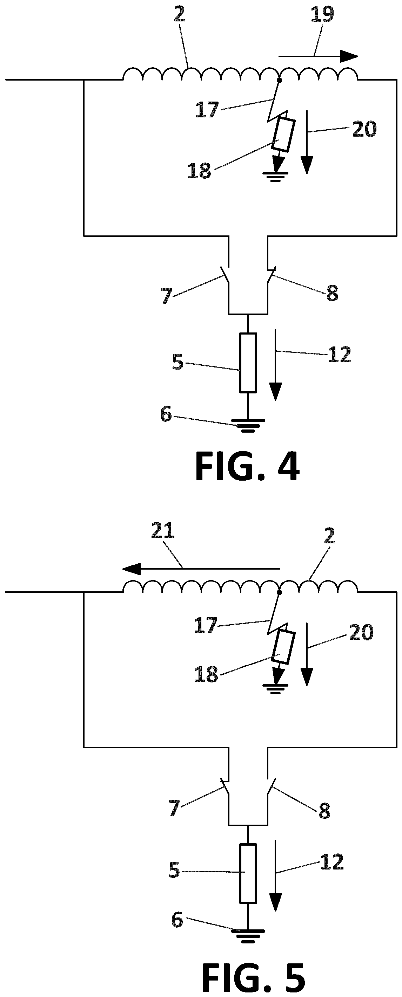

Figures 4 and 5 show the voltage distribution of the fault circuit for the switches connected in neutral and phase, respectively. The circuit of Figure 4 has a ground fault (17) with a fault resistance (18) that defines the severity of the defect. In said circuit, the voltage in the grounding device (12), considered as a current limiting resistance with a high ohmic value can be expressed as: ${U}_{gnd . n} = x \frac{{R}_{gnd}}{{R}_{gnd} + {R}_{f}} {U}_{in}$ where *x·Uᵢₙ* is the fault-to-neutral voltage (19) and *U_{gnd.n}* is the voltage in the device (5), forming a voltage divider with respect to *R_{F}*. Moreover, the circuit of Figure 5 has the same position of the ground fault (17) with the same fault resistance, *R_{F}* (18). In this circuit, the grounding impedance of the grounding device (5) is connected in the terminal posts of the terminal (3) of the electric machine connected to the rest of the electrical system, so the voltage divider will now act with (*1-x*)·*Uᵢₙ* which is the fault-to-phase voltage (21). Therefore, the voltage in the grounding device (12) can be expressed as: ${U}_{gnd . ph} = \left(1-x\right) \frac{{R}_{gnd}}{{R}_{gnd} + {R}_{f}} {U}_{in}$

Therefore, generically, the voltage (12) can be expressed as: ${U}_{gnd} = \left(X-x\right) \frac{{R}_{gnd}}{{R}_{gnd} + {R}_{f}} {U}_{in}$ where X is the per-unit position within the winding (2) of the connection point of the switch which is closed at the time of recording the voltage *U_{gnd}* (12).

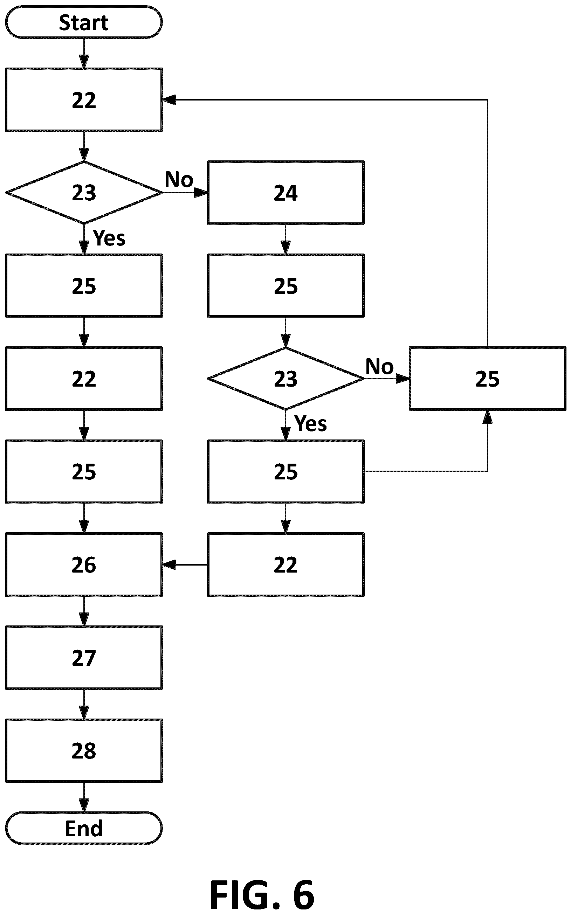

Figure 6 shows a possible embodiment of the method of the invention performed with respect to Figure 3. First, the method will use a step of measuring voltages (22) in which voltage signals *U_{gnd}* (12) and *Uᵢₙ* (13) are recorded. Next, in a step of checking for ground fault (23) the checking for fault is performed, where if ${U}_{gnd} > {U}_{th}$ with *Uₜₕ* being a threshold voltage value previously set by the user after which the diagnosis is activated, the system detects a ground fault.
- If the value is greater than the threshold, the diagnosis of ground fault is performed comprising a step of commutating the grounding switches (25) which now changes the *R_{gnd}* arrangement to the terminal (3) of the faulty phase with the knowledge that *U_{gnd}* (12) is in counterphase with the phase voltage (13) of the phase affected by the fault. In this position, the step of measuring voltages (22) is performed again to obtain the parameters corresponding to this connection and said parameters are stored. For the safety and stability of the electric machine, *R_{gnd}* is returned to neutral by performing the step of commutating the grounding switches (25) again.

With *U_{gnd.n}, U_{gnd.ph}* and *Uᵢₙ* measurements, a step of calculating fault position (26), x, is performed where it is estimated as: $x = 1 - \frac{1}{1 + \frac{{U}_{gnd . n}}{{U}_{gnd . ph}}}$

When the position, x, a step is then performed to calculate the fault impedance (27), which estimates the *R_{F}* of the defect and which is an indicator inversely proportional to the severity of the defect, as: ${R}_{f} = {R}_{gnd} \left(\frac{{xU}_{in}}{{U}_{gnd . n}}-1\right)$

Once obtaining the fault detection and faulty phase, location, and severity, a step of emitting diagnosis and alarm (28) is carried out.
- If the value is less than the threshold, a step of waiting for commutation (24) is performed, where after a time established by the user has elapsed, a step of commutating the grounding switches (25) is performed, arranging the grounding device (5) in the terminals of the machine in case the selectivity of the protection is not high enough due to a ground fault that is very close to the neutral point of the system. Once the switch is commutated, the step of checking for ground fault (23) using the voltage measurements from this another connection point is performed again. If it is still below threshold, there is no ground fault and the method enters a waiting loop, measuring voltages in the neutral of the electric machine again. If on the contrary, Ugnd > Uth, then, for the safety and stability of the electric machine, *R_{gnd}* is returned to neutral by performing the step of commutating the grounding switches (25) again and the steps for the diagnosis of location and estimation of the severity of the ground fault (26, 27) described in the preceding section are performed.

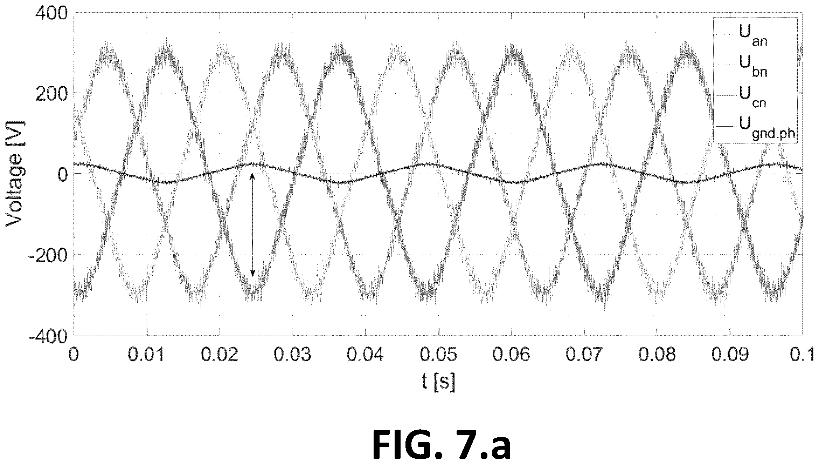

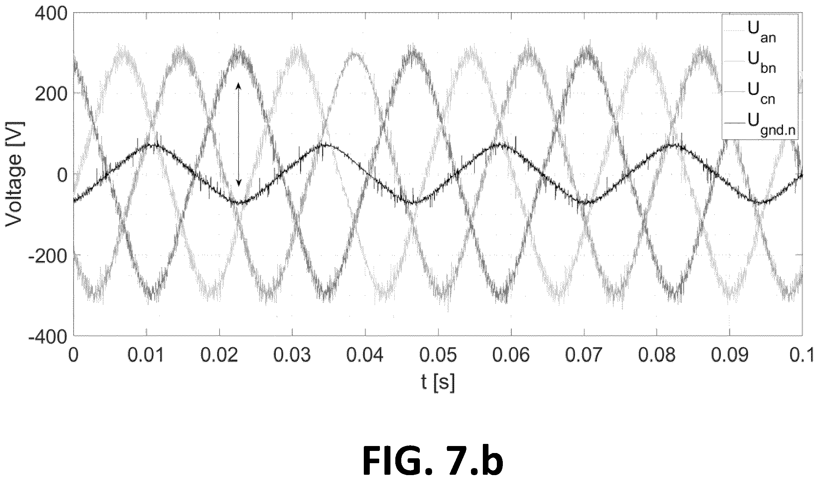

Finally, Figure 7 shows a numerical example of a possible embodiment of the invention with respect to a 3.5 kW synchronous electric machine with permanent magnets having a fault in 25% of its winding with fault resistance of 10 kΩ (both data x, *R_{F},* unknown a priori). The grounding impedance is 4.7 kΩ to limit the defect current to safe levels for the machine and people. Figure 7a shows a record of phase-neutral voltages and *U_{gnd}* for the position of the closed switch (8) at the neutral point of the system. Figure 7b shows a record of phase-neutral voltages and *U_{gnd}* for the position of switch (7c) since it can be deduced from the preceding graph that the faulty phase is phase "c" since *U_{cn}* is in counterphase with *U_{gnd}.* From this data, the following is obtained: *U_{cn}* = 197.275 V, *U_{gnd.n} =* 15.268 V, and *U_{gnd.ph}* = 47.661 V. Therefore, the result of the application of the method is: x = 24.26% and *R_{f}* = 10.0326 kΩ.

## Claims

1. A system for the detection and location of ground faults in the windings of electric machines which allows locating a first ground fault with the system in operation, **characterized in that** it comprises the following subsystems:
- at least one grounding device connected between at least two switches positioned at two different points of the system to be protected and the ground;
- at least one voltage or current meter for measuring voltage or current in the terminal posts of the grounding device, respectively;
- at least one voltage meter for measuring voltage in the phases of the electric machine or for measuring line-to-line voltage between phases of the electric machine;
- a commutation subsystem between at least the two different points of the system to be protected for controlling the switches connected to the grounding device and which allows the grounding to be moved between at least these two points; and
- a master subsystem for the diagnosis of ground faults in electric machines which controls the commutation subsystem and allows knowing the position of the grounding device with respect to the system to be protected, collects voltage and/or current signals at least from the meters, for all the previously commutated positions, and detects the grounding defect if a voltage and/or current in the grounding device exceeds a certain pre-established threshold.

2. The system for the detection and location of ground faults in the windings of electric machines according to claim 1, **characterized in that** the master subsystem for the diagnosis of ground faults is furthermore adapted to distinguish the defective phase by means of comparing the phase or line-to-line voltages with respect to the voltage/current in the grounding device, to locate the defect using the phase/line voltage/current measurements and measurements from the grounding device for at least two commutation positions of this grounding device, to estimate the severity of the defect once it is located, and to emit an alarm and diagnostic signal to external devices.

3. The system for the detection and location of ground faults in the windings of electric machines according to claim 1, **characterized in that** the grounding device is a grounding impedance.

4. The system for the detection and location of ground faults in the windings of electric machines according to claim 3, **characterized in that** the grounding impedance has an ohmic value suitable for limiting the defect current to low values in order to prevent the electric machine to be protected from being damaged with a first ground fault.

5. The system for the detection and location of ground faults in the windings of electric machines according to claim 1, **characterized in that** the commutation subsystem for commutating the switches of the points of the system with the grounding device has an electrical interlock between the switches to prevent turn and/or phase short circuit in the case where they are both operated at the same time.

6. The system for the detection and location of ground faults in the windings of electric machines according to claim 1, **characterized in that** the master subsystem for the diagnosis of ground faults
detects the ground fault if the voltage in the grounding device, *U_{gnd},* is greater than a certain threshold value, *Uₜₕ,* such that: ${U}_{gnd} > {U}_{th}$ and which can also be applied to current, (*I_{gnd} > Iₜₕ*).

7. The system for the detection and location of ground faults in the windings of electric machines according to claim 2, **characterized in that** the master subsystem for the diagnosis of ground faults is adapted to distinguish the defective phase such that *U_{gnd}* is in counterphase with the phase-neutral voltage, *Uᵢₙ*, of the faulty phase, either measured or estimated from line voltages, as: ${θ}_{{U}_{gnd}} - {θ}_{{U}_{in}} = 180 ° \pm ε$ where *ε* is the tolerance in angular difference between phasors *U_{gnd}* and *Uᵢₙ*, with "*i*" being the faulty phase.

8. The system for the detection and location of ground faults in the windings of electric machines according to claim 2, **characterized in that** the master subsystem for the diagnosis of ground faults is adapted to
locate the position of the grounding defect, x, by solving the following system of equations: $\left\{\begin{matrix}{U}_{gnd . n} = x \frac{{R}_{gnd}}{{R}_{gnd} + {R}_{f}} {U}_{in} \\ {U}_{gnd . ph} = \left(1-x\right) \frac{{R}_{gnd}}{{R}_{gnd} + {R}_{f}} {U}_{in}\end{matrix}\right.$ where *U_{gnd.n}* is the voltage measurement in the grounding device for the commutation position in the neutral of the system to be protected, *U_{gnd.ph}* is the voltage measurement in the grounding device for the commutation position in the terminals of the machine to be protected, *R_{F}* is the fault resistance, which is inversely proportional to the severity of the defect, and *R_{gnd}* is the impedance of the grounding device; therefore: $x = 1 - \frac{1}{1 + \frac{{U}_{gnd . n}}{{U}_{gnd . ph}}}$
o estimate the severity of the defect once the fault position is known, as: ${R}_{f} = {R}_{gnd} \left(\frac{{xU}_{in}}{{U}_{gnd . n}}-1\right)$ and emit an alarm and diagnostic signal with information about defect detection, faulty phase, location within the winding, and severity of the defect.

9. The system for the detection and location of ground faults in the windings of electric machines according to any of the preceding claims, **characterized in that** the electric machine is: a squirrel cage induction machine, a synchronous machine, or a transformer.

10. A method for the detection and location of ground faults in the windings of electric machines which allows locating a first ground fault with the system in operation, **characterized in that** it comprises the following steps:
- at least one step of measuring voltages which records the voltage signals in the grounding device and the phase/line voltage measurements of the electric machine to be protected;
- at least one step of checking for ground fault where the voltage measurement in the grounding device is compared with a preset trip threshold;
- at least one step of waiting for the commutation of the switches connecting two or more points of the electric machine with the grounding device;
- at least one step of commutating the grounding switches which must allow the step of measuring voltages to be performed from another different point of the electric machine;
- at least one step of calculating the fault position which uses at least two previously described positions and their respective voltage and/or current measurements in the grounding device and in the grounding line and/or phase voltage.

11. The method for the detection and location of ground faults in the windings of electric machines according to claim 10, **characterized in that** in the step of calculating the fault position, the diagnosis for distinguishing the faulty phase of the electric machine is performed such that: ${θ}_{{U}_{gnd}} - {θ}_{{U}_{in}} = 180 ° \pm ε$ where *θ_{Ugnd}* is the angle of the phasor of the voltage in the grounding device, *θ_{Uin}* is the voltage angle of faulty phase "*i*" of the electric machine, and ε is the tolerance/deviation set by the user, wherein said step of calculating the fault position, locates the defect within the faulty winding with at least two commutation points; where *U_{gnd.n}* is the voltage measurement in the grounding device for the commutation position in the neutral of the system to be protected, *U_{gnd.ph}* is the voltage measurement in the grounding device for the commutation position in the terminals of the machine to be protected;
- at least one step of calculating fault impedance which allows estimating the severity of the defect;
- at least one step of emitting alarm and diagnosis to protective devices external to the invention.

12. The method for the detection and location of ground faults in the windings of electric machines according to claim 10, **characterized in that** the step of waiting for the commutation of the switches connecting two or more points of the electric machine with the grounding device sends a switch commutation signal once the wait time previously preset by the user runs out to perform the diagnosis at another different grounding point of the electric machine to be protected.

13. The method for the detection and location of ground faults in the windings of electric machines according to claim 10, **characterized in that** the step of commutating the grounding switches must open commutator prior to or simultaneously with the introduction of another switch to prevent short circuits without limiting impedance to ground.

14. The method for the detection and location of ground faults in the windings of electric machines according to claim 10, **characterized in that** the step of calculating the fault position estimates the position of the defect such that $x = 1 - \frac{1}{1 + \frac{{U}_{gnd . n}}{{U}_{gnd . ph}}}$ where *U_{gnd.n}* is the voltage measurement in the grounding device for the commutation position in the neutral of the system to be protected, *U_{gnd.ph}* is the voltage measurement in the grounding device for the commutation position in the terminals of the machine to be protected.

15. The method for the detection and location of ground faults in the windings of electric machines according to claim 10, **characterized in that** the step of calculating fault impedance estimates the grounding fault impedance *R_{f}*, as: ${R}_{f} = {R}_{gnd} \left(\frac{{xU}_{in}}{{U}_{gnd . n}}-1\right)$ where *R_{gnd}* is the grounding impedance, *Uᵢₙ* is the phase-neutral voltage of the faulty phase, and *U_{gnd.n}* is the voltage in the grounding impedance for the switch position in the neutral of the electric machine.

16. The method for the detection and location of ground faults in the windings of electric machines according to claim 10, **characterized in that** the step of emitting alarm and diagnosis emits signals with at least information about ground fault detection, phase having said problem, location of the defect position, and severity of the fault.
